Europäisches Patentamt

European Patent Office

Office européen des brevets

(19)

(11) Numéro de publication : **0 326 474 B1**

(12) **FASCICULE DE BREVET EUROPEEN**

(45) Date de publication du fascicule du brevet :
21.04.93 Bulletin 93/16

(51) Int. Cl.$^5$ : **G01R 33/24**

(21) Numéro de dépôt : **89400187.4**

(22) Date de dépôt : **24.01.89**

(54) Oscillateur pour la mesure du champ magnétique ambiant.

(30) Priorité : **26.01.88 FR 8800960**

(43) Date de publication de la demande :
**02.08.89 Bulletin 89/31**

(45) Mention de la délivrance du brevet :
**21.04.93 Bulletin 93/16**

(84) Etats contractants désignés :
**DE FR GB IT**

(56) Documents cités :
**US-A- 3 376 500**
**JOURNAL OF PHYSICS E: SCIENTIFIC INS-
TRUMENTS, vol. 12, no. 8, août 1979, pages
731-733, The Institute of Physics, Bristol, GB;
C. BLANC et al.: "Frequency-to-magnetic-field
converter for nuclear magnetic resonance
magnetometer"**

(56) Documents cités :
**JOURNAL OF PHYSICS E: SCIENTIFIC INS-
TRUMENTS, vol. 9, no. 4, avril 1976, pages
283-286, Bristol, GB; J.K. HULBERT: "A field
tracking digital NMR magnetometer for in situ
use with superconducting solenoids"**
**NUCLEAR INSTRUMENTS AND METHODS,
vol. 147, no. 3, décembre 1977, pages 595-598,
North-Holland Publishing Co, Amsterdam, NL;
J. TZENG LUE: "An automatic tracking
nuclear magnetic resonance gaussmeter"**
**REVIEW OF SCIENTIFIC INSTRUMENTS, vol.
53, no. 9, septembre 1982, pages 1414-1417,
American Institute of Physics, New York, US;
K.H. CARPENTER et al.: "Phase-locked
yttrium iron garnet magnetometer for remote
measurement of small field changes in a fluctuating background"**

(73) Titulaire : **SEXTANT Avionique
5/7 rue Jeanne Braconnier Parc Tertiaire
F-92368 MEUDON LA FORET Cédex (FR)**

(72) Inventeur : **Lescourret, Jean-Louis
10 rue Turbot
F-26500 Bourg les Valence (FR)**

(74) Mandataire : **Bloch, Gérard et al
2, square de l'Avenue du Bois
F-75116 Paris (FR)**

EP 0 326 474 B1

## Description

La présente invention a pour objet un oscillateur dont la fréquence d'oscillation est proportionnelle à l'intensité du champ magnétique ambiant, utilisé en vue de la mesure dudit champ magnétique, et comprenant une sonde magnétométrique à résonance magnétique pour détecter, en réponse notamment à un signal d'excitation basse fréquence, un signal à la fréquence de ladite résonance magnétique et des moyens pour engendrer, en réponse au signal détecté, ledit signal d'excitation basse fréquence.

La présente invention concerne donc notamment les magnétomètres à résonance magnétique nucléaire (RMN).

De telles sondes sont connues dans la technique et divers types de magnétomètres à RMN sont par exemple décrits dans les demandes de brevets français 1 447 226, 2 098 624 et 2 583 885. On rappellera que cet appareil comprend au moins deux échantillons liquides contenus dans des flacons, ces flacons étant disposés dans une cavité résonante excitée à très haute fréquence. Un détecteur comprend des enroulements autour desdits flacons pour le prélèvement et la réinjection d'un signal à la fréquence de Larmor définie d'une part par le champ magnétique dans lequel baigne la sonde et d'autre part par la rapport gyromagnétique propre aux échantillons liquides contenus dans les flacons.

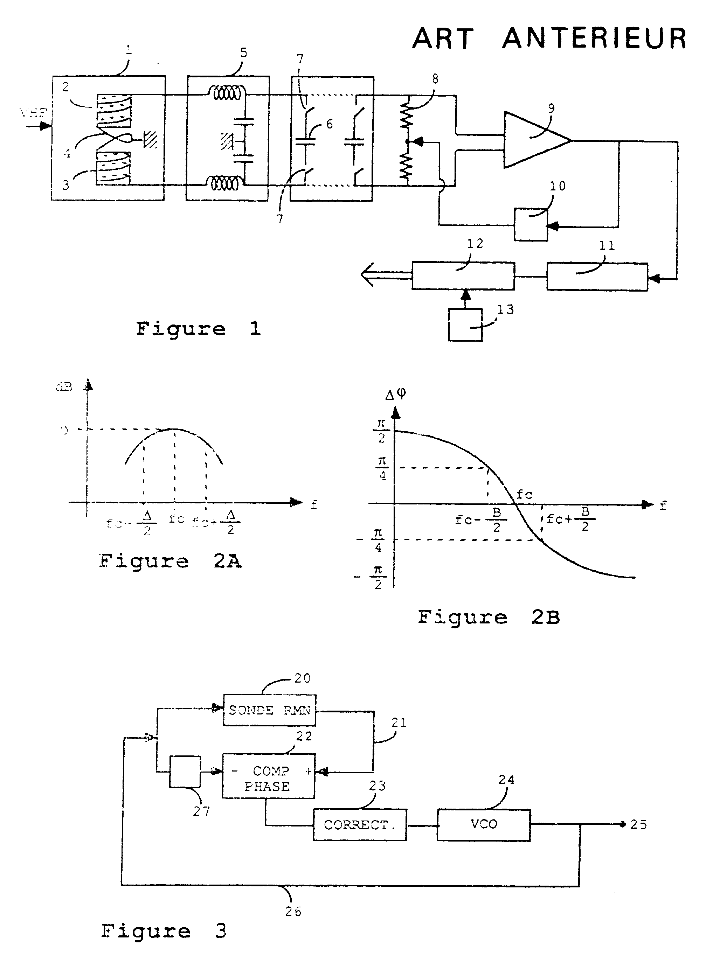

La figure 1 représente un exemple de sonde RMN montée dans un oscillateur nucléaire selon l'art antérieur. Dans cette figure, le bloc 1 désigne une sonde RMN comprenant deux flacons 2 et 3, un enroulement détecteur et excitateur basse fréquence 4, l'ensemble étant disposé dans une cavité excitée par un signal à très haute fréquence noté VHF. Le point milieu de l'enroulement 4 est ici relié à la masse et les deux extrémités de l'enroulement 4 forment deux accès de la sonde. Un filtre double 5, pour éliminer la fréquence VHF est pourvu de deux entrées reliées à ces deux accès, et de deux sorties. Entre ces deux sorties sont disposés une succession de condensateurs 6 en parallèle dont deux seulement sont représentés et qui peuvent être mis en service ou non par des commutateurs 7 pour réaliser un filtrage du bruit autour de la fréquence de Larmor, en relation avec les self inductances de l'enroulement 4 et des résistances 8, résistances 8 également connectées en parallèle sur les condensateurs 6. Les sorties du filtre double basse fréquence 6, 7, 8 ainsi formé sont connectées aux entrées d'un circuit d'amplification large bande 9 comprenant des étages préamplificateurs et amplificateurs. La sortie du circuit d'amplification 9 est renvoyée d'une part au point milieu des résistances 8, éventuellement par l'intermédiaire d'un circuit déphaseur 10 introduisant un déphasage de 90 degrés, et d'autre part à un ensemble de mesure de fréquence comprenant un système de numérisation et de filtrage numérique 11 et un fréquencemètre 12 qui est généralement connecté à une horloge de haute précision 13. La sortie du fréquencemètre 12 est par exemple appliquée à un microprocesseur pour gérer les informations reçues qui représentent les valeurs mesurées du champ magnétique et éventuellement les coder et les réémettre vers un circuit utilisateur.

Ainsi, l'ensemble des éléments 1 à 10 constitue ce qui est appelé habituellement un oscillateur nucléaire qui oscille normalement à la fréquence de précession des spins nucléaires (ou fréquence de Larmor $f_O$) si des conditions de gain et de phase convenables sont respectées. Or, par suite de dissymétries géométriques et électroniques ou d'effets parasites sur les enroulements et bobines (effets capacitifs, couplage entre bobines), ce montage risque de constituer un oscillateur à la fréquence propre des bobines, généralement comprise entre 10 et 25 kHz selon la capacité parasite en parallèle avec les bobinages, notamment celle apportée par les câbles reliant les bobinages à l'amplificateur. Il est donc nécessaire d'injecter un signal d'excitation exempt de toute énergie en dehors d'une bande de quelques centaines de Hz autour de la fréquence de Larmor, qui est généralement selon les conditions dans lesquelles est placée la sonde comprise entre 1000 et 3000 Hz. Dans le montage classique de la figure 1, ce problème est résolu par l'ensemble de filtrage susmentionné constitué des résistances 8 et d'un ou plusieurs des condensateurs 6 qui sont sélectivement connectés en parallèle avec les bobinages selon l'état des interrupteurs 7 (en pratique, ces interrupteurs 7 seront des interrupteurs à semiconducteur, par exemple des transistors MOS).

Cette solution présente plusieurs inconvénients liés, d'une part, au déphasage important et variable apporté par ce mode de filtrage, et d'autre part, à la sensibilité à la température qui en résulte, sans compter le problème posé par le choix initial du condensateur à brancher dans le filtre. Un tel filtrage ne pourra pas avoir une bande passante très étroite. On aura au mieux des bandes passantes de l'ordre de quelques centaines de Hz.

De plus, même si l'ensemble des éléments 1 à 10 de la figure 1 permettait de constituer un oscillateur nucléaire satisfaisant, il reste à mesurer la fréquence de fonctionnement de cet oscillateur. Pour cela, on arrive généralement dans l'art antérieur à la solution lourde représentée consistant à utiliser une numérisation et un filtrage numérique par le filtre 11 avant d'effectuer une mesure par un fréquencemètre. En effet, de façon classique la mesure de la fréquence f d'un signal s'obtient à partir de la mesure de la période $T_s$ de ce signal à l'aide d'une horloge de précision de fréquence $F_H$ dont on compte le nombre $N_p$ de périodes pendant un temps

EP 0 326 474 B1

correspondant à un multiple de périodes du signal, $nT_s$ ; la fréquence mesurée vaut alors :

$$f = nF_H/N_p$$

Cette procédure n'est utilisable que si le signal dont on veut mesurer la fréquence a un bruit faible correspondant à une phase aléatoire instantanée relativement faible, c'est-à-dire inférieure à $2\pi$ d'au moins un ordre de grandeur. De plus, pour obtenir un précision élevée, il faut filtrer le signal pour éliminer l'énergie du bruit hors de la bande $\pm 1/2T_c$ autour de la raie de résonance, $T_c$ étant le temps de comptage ($T_c = nT_s$). De cette façon, le phénomène bien connu de repliement des fréquences en présence d'un échantillonnage est minimisé et la mesure de fréquence est ainsi obtenue avec la précision requise. Mais ceci entraîne la nécessité dans les techniques de l'art antérieur d'utiliser un filtre numérique avant le fréquencemètre. On notera qu'un tel filtre numérique constitue un appareillage lourd comprenant lui-même des microprocesseurs.

En outre, même avec ces précautions, la fréquence mesurée ne sera pas la fréquence de Larmor $f_O$ mais une fréquence $f_m = f_O + tg\phi/T$ où T est le temps de relaxation de la sonde qui varie avec la température et $\phi$ un déphasage lié notamment à la présence du filtre à condensateurs commutables et aux divers étages d'amplification. Ce déphasage n'est pas prédéterminable et correspond donc à une erreur. En fait, le facteur d'erreur $tg\phi/T$ est de l'ordre de $10^{-3} f_O$. Ceci ne constitue pas a priori une limitation pour les mesures classiques. En effet, ce n'est généralement pas $f_O$ que l'on cherche à mesurer mais les variations de $f_O$ et si le terme d'erreur était constant cela ne poserait pas de problème. Mais en fait, il apparaît que les valeurs T et $\phi$ varient avec le temps et la température et qu'ainsi, fondamentalement, ce système ne peut fournir une précision supérieure à $10^{-6}$ sur des durées supérieures à une minute.

En conséquence, un but de la présente invention est de prévoir un nouveau circuit d'oscillateur nucléaire minimisant les inconvénients des dispositifs de l'art antérieur susmentionnés.

Un but plus particulier de la présente invention est de filtrer de façon simple avec un circuit de faible encombrement, de faible consommation et de faible coût le signal d'oscillation d'un oscillateur nucléaire.

Un autre but de l'invention est de filtrer le signal nucléaire réinjecté dans l'oscillateur nucléaire de façon à éviter toute oscillation parasite à la fréquence propre des bobinages.

Un autre but de la présente invention est de prévoir un tel système qui permette une mesure de fréquence avec une précision de l'ordre de $10^{-3}$.

Un autre but de la présente invention est de regrouper la fonction de filtrage du signal précédant le fréquencemètre et la fonction de filtrage du signal nucléaire réinjecté dans un seul dispositif placé à l'intérieur de l'oscillateur nucléaire.

En d'autres termes, un problème que l'invention vise à résoudre est le fonctionnement correct d'un oscillateur nucléaire dans toute la gamme de fréquences possibles de fonctionnement (couramment de 1000 à 3000 Hz) et dans un vaste domaine de températures.

Un autre problème que la présente invention vise à résoudre concerne la mesure de la fréquence avec une précision de quelques $10^{-3}$ pour des fréquences allant de 1000 à 3000 Hz.

La présente invention a donc pour objet un oscillateur dont la fréquence d'oscillation est proportionnelle à l'intensité du champ magnétique ambiant, utilisé en vue de la mesure dudit champ magnétique, et comprenant une sonde magnétométrique à résonance magnétique pour détecter, en réponse à un signal d'excitation basse fréquence, un signal à la fréquence de ladite résonance magnétique et des moyens pour engendrer, en réponse au signal détecté, ledit signal d'excitation basse fréquence, caractérisé par le fait que lesdits moyens de génération comprennent une boucle d'asservissement de la phase dudit signal d'excitation basse fréquence sur la phase dudit signal détecté, et des moyens d'initialisation pour que ledit signal d'excitation basse fréquence balaye une plage de fréquences lorsque ladite boucle n'est pas accrochée.

Avantageusement, lesdits moyens de génération délivrent ledit signal d'excitation basse fréquence sous forme numérique, et ladite boucle utilise, comme comparateur de phase, un premier convertisseur numérique analogique dont l'entrée numérique reçoit ledit signal d'excitation basse fréquence sous forme numérique et dont l'entrée de polarisation reçoit ledit signal détecté par ladite sonde.

Avantageusement encore, lesdits moyens de génération comprennent :
- un oscillateur à fréquence commandée par la tension de sortie du comparateur de phase et fournissant un signal en créneaux, de fréquence égale à N fois la fréquence dudit signal d'excitation basse fréquence, N étant un entier positif,
- un compteur de capacité N recevant la sortie dudit oscillateur à fréquence commandée et délivrant donc en sortie un signal numérique dont la valeur varie de 1 à N de façon cyclique, et,
- une première mémoire, adressée par ledit compteur, contenant des valeurs d'une fonction sinusoïdale de $2\pi i/N$, dont la sortie est ledit signal d'excitation basse fréquence sous forme numérique.

Avantageusement encore, N est compris entre 32 et 4096 ($2^5$ et $2^{12}$).

Avantageusement encore, ledit signal d'excitation basse fréquence appliqué à ladite sonde est obtenu à

3

EP 0 326 474 B1

partir d'une deuxième mémoire contenant des valeurs d'une fonction sinusoïdale de $2\pi$ i/N, décalée de 90° par rapport à celle de ladite première mémoire, adressée par ledit compteur, et dont la sortie est transmise à ladite sonde par l'intermédiaire d'un deuxième convertisseur numérique/analogique.

Ainsi, la présente invention prévoit d'injecter dans une sonde de magnétomètre à RMN un signal d'excitation exempt de toute énergie en dehors d'une bande de quelques Hz autour de la fréquence de Larmor. D'autre part, la présente invention vise à réinjecter ce signal à partir d'un filtre à bande très étroite de sorte que le déphasage entre le signal d'injection et la sortie de l'amplificateur du signal de la sonde RMN soit sensiblement constant et pratiquement nul pour tout le domaine de fréquences et de températures. Ce signal est donc toujours centré sur la fréquence de Larmor, à une erreur près due aux déphasages résiduels des bobines, et surtout de l'amplificateur malgré sa grande bande passante.

Du fait que l'on a un signal filtré dans une bande très étroite, celui-ci peut directement être exploité par un fréquencemètre à comptage.

Ces objets, caractéristiques et avantages de la présente invention seront exposés plus en détail dans la description suivante de modes de réalisation particuliers faite en relation avec les figures jointes parmi lesquelles :

- la figure 1, décrite précédemment, représente un schéma d'un oscillateur à résonance magnétique nucléaire de l'art antérieur,
- les figures 2A et 2B représentent des caractéristiques décrites précédemment d'amplitude et de phase d'une sonde RMN en fonction de sa fréquence d' excitation,
- la figure 3 représente le schéma général d'un oscillateur selon la présente invention,
- la figure 4 représente un schéma sous forme de blocs plus détaillé d'un oscillateur selon la présente invention et de son application à une sonde RMN, et,
- la figure 5 représente plus en détail une partie du schéma sous forme de blocs de la figure 4 comprise entre le comparateur de phase et un oscillateur à fréquence commandée par une tension.

Les figures 2A et 2B représentent respectivement la caractéristique amplitude/fréquence et la caractéristique phase/fréquence d'une sonde RMN considérée comme un filtre. On voit à partir de la caractéristique phase/fréquence de la figure 2B que la phase $\Delta\varphi$ est une fonction sensiblement linéaire de la différence entre la fréquence d'excitation f et la fréquence de résonance fc, pour une bande de fréquences d'excitation comprises entre fc-B/2 et fc + B/2, et correspondant à des valeurs de phase variant entre + $\pi/4$ et - $\pi/4$. Par contre, dans cette plage de fréquences la figure 2A montre que l'amplitude D du signal de résonance est sensiblement constante.

La présente invention s'appuie sur cette observation et propose, plutôt que d'utiliser un filtrage passe-bande du signal de la sonde, de réaliser un asservissement de phase entre le signal d'excitation et le signal de sortie de la sonde.

La figure 3 représente sous forme de blocs la présente invention sous son aspect le plus général. Etant donné une sonde RMN 20, celle-ci, si elle est convenablement excitée, fournit en sortie le signal basse fréquence 21 dont on veut déterminer la pulsation $\omega_o$ (ou la fréquence $f_O$). Ce signal est envoyé à la première entrée d'un comparateur de phase 22 dont la sortie est reliée à un filtre très basse fréquence 23 et un oscillateur à fréquence commandée par sa tension d'entrée (VCO) 24. La sortie du VCO 24 est envoyée, d'une part, sur une borne 25 à un fréquencemètre, non représenté, pour mesurer la fréquence de résonance de la sonde RMN et donc le champ magnétique détecté, et d'autre part, par une boucle 26, à l'entrée d'excitation basse fréquence de la sonde RMN et à une entrée négative du comparateur de phase 22 pour réaliser l'asservissement de phase. Un déphaseur 27 fournissant un déphasage déterminé peut être utilisé pour compenser un déphasage constant entre l'entrée et la sortie de la sonde, couramment de 90°.

Ce procédé, sous son aspect général, à savoir d'utilisation d'une comparaison de phase entre le signal d'excitation et le signal de résonance de sortie d'une sonde RMN pour caler la fréquence de l'oscillateur nucléaire comprenant cette sonde le plus près possible de la fréquence de Larmor constitue l'un des aspects importants de la présente invention.

En effet, dans la présente invention, la boucle d'asservissement de phase fait partie de la boucle de réaction de l'oscillateur formé par l'amplificateur et la sonde RMN.

Il s'agit là d'une utilisation inhabituelle d'une boucle à verrouillage de phase qui est classiquement utilisée quand deux systèmes situés à distance l'un de l'autre doivent être strictement asservis, par exemple un émetteur et un récepteur de télévision, pour régler finement une horloge locale du récepteur par rapport à une horloge de l'émetteur. Mais, dans ce cas, on sait a priori quelle est la valeur de l'horloge de l'émetteur et l'on cherche simplement à faire un réglage fin d'un oscillateur prévu au niveau du récepteur pour l'adapter très exactement au signal d'horloge émis. Une telle utilisation de la boucle à verrouillage de phase consisterait, dans le cas de la figure 1, à l'utiliser à l'extérieur de la boucle de réaction de l'oscillateur qui délivre le signal dont on doit mesurer la fréquence. Cette boucle de réaction comprenant ici les éléments 1,5,6,8,9 et 10, la boucle à verrouil-

4

lage de phase serait utilisée par exemple à la place du circuit 11, et non, comme dans la présente invention dans cette boucle de réaction elle-même qui donne naissance au signal utile.

Ici, le problème est donc tout à fait différent, et de plus, le signal émis que l'on cherche d'une part à filtrer, ou en d'autre termes à reconstituer par la boucle à verrouillage de phase, peut varier dans une très grande plage de fréquences, voisine de 2 octaves, par exemple de 1000 à 3000 Hz comme cela a été indiqué précédemment.

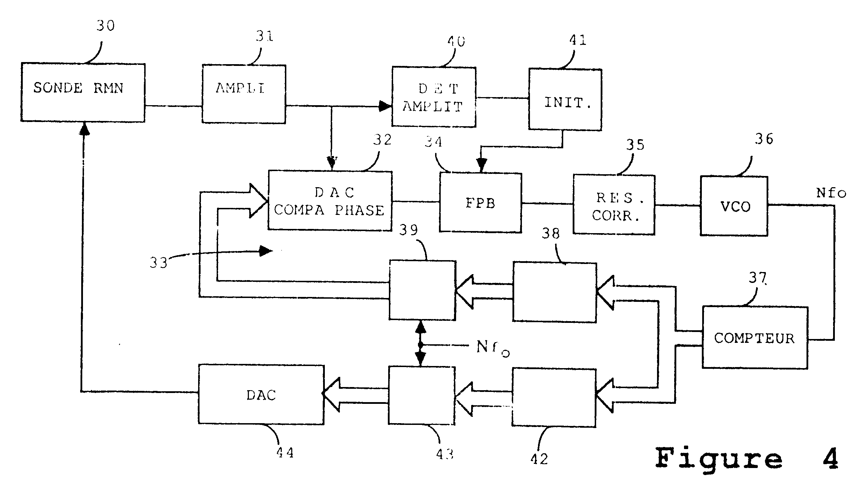

D'autre part, la présente invention prévoit des moyens pour faire fonctionner une boucle à verrouillage de phase dans l'application particulière considérée. Ces moyens seront décrits plus en détail dans le cadre d'un mode de réalisation en relation avec la figure 4. Dans la figure 4, on peut voir une sonde RMN 30 équivalente à la sonde 20 de la figure 3 dont la sortie est amplifiée par un premier amplificateur 31. La sortie de l'amplificateur 31 est envoyée à l'entrée de tension de référence, ou entrée de polarisation, d'un convertisseur numérique/analogique 32. Ce convertisseur numérique/analogique constitue le comparateur de phase d'une boucle à verrouillage de phase 33 qui comprend essentiellement un filtre passe-bas 34 par exemple un filtre du deuxième ordre, un réseau correcteur 35, un VCO 36, un compteur 37, une mémoire de fonction sinusoïdale 38 et une bascule tampon (LATCH) 39. D'autre part, la sortie de l'amplificateur 31 est également envoyée à un détecteur d'amplitude 40 suivi d'un circuit d'initialisation 41. La sortie du compteur 37 est également transmise à une deuxième mémoire de fonction sinusoïdale 42 et à une deuxième bascule tampon 43 dont la sortie est envoyée par l'intermédiaire d'un convertisseur numérique/analogique 44 à l'entrée d'excitation basse fréquence de la sonde RMN, ce qui correspond au signal réinjecté 26 de la figure 3. De même, le signal envoyé à l'entrée numérique du convertisseur numérique/analogique 32 correspond au signal 26 de la figure 3 déphasé par le déphaseur 27 de la figure 3 envoyé à l'entrée de comparaison du comparateur de phase 22 de la figure 3 ; en effet, les deux mémoires de fonctions sinusoïdales 38 et 42 ont pour objet de fournir des fonctions sinusoïdales déphasées de $\pi/2$, par exemple un cosinus et un sinus.

En supposant la boucle accrochée, c'est-à-dire fonctionnant sur la fréquence de Larmor $f_O$ de la sonde, le fonctionnement de cette boucle est le suivant. L'oscillateur VCO 36 fournit un signal sensiblement en forme de créneaux à une fréquence $Nf_O$, N étant un entier, par exemple compris entre 32 et 4096 ($2^5$ et $2^{12}$). Le compteur 37 est un compteur de capacité N qui compte en permanence des créneaux et délivre donc en sortie un signal numérique dont la valeur varie de 1 à N (ou de 0 à N-1) de façon cyclique. Ces valeurs 1 à N sont fournies comme valeurs d'adresse à la mémoire 38 qui contient les valeurs de la fonction $\cos 2\pi i/N$ ; c'est-à-dire que l'on a en sortie de la mémoire 38 un échantillonnage à N valeurs de la fonction $\cos 2\pi f_O$. Cette sortie, synchronisée par la bascule 39 recevant le signal $Nf_O$ du VCO, est envoyée au convertisseur numérique/analogique 32 dont l'entrée de tension de référence ou entrée de polarisation est le signal amplifié de sortie de la sonde, c'est-à-dire, normalement, si la boucle est effectivement verrouillée sur la bonne fréquence, le signal $A\sin(2\pi f_O t + \phi)$.

On obtient donc, en sortie du convertisseur numérique/analogique 32 un signal analogique proportionnel au produit du signal de sortie de la sonde, appliqué à l'entrée de polarisation, par un signal $\cos 2\pi fo$ appliqué sous forme numérique à l'entrée numérique. Ce signal en sortie du convertisseur numérique/analogique 32 comprend donc un signal d'erreur proportionnel au déphasage entre le signal $\cos 2\pi fo$ et le signal de sortie de la sonde auquel se superposent les signaux à la fréquence $2f_O$ et un terme résiduel à la fréquence $f_O$. Comme cela est classique, ce signal est filtré par un filtre passe-bas très basse fréquence 34 afin de supprimer les termes en $f_O$ et $2f_O$ suivi d'un réseau correcteur 35 à l'entrée du VCO 36. Le réseau correcteur 35 est essentiellement un réseau à avance de phase destiné à assurer la stabilité du système avec une marge de gain ou de phase suffisante comme cela sera précisé ci-après.

Comme le montrent les calculs, pour qu'une telle boucle de verrouillage de phase puisse s'accrocher, il faut que les fréquences des signaux aux deux entrées du convertisseur analogique/numérique 32 soient extrêmement proches (écart de quelques Hz). Or, à la mise sous tension du système, il n'y a aucune raison pour que la fréquence de sortie du VCO corresponde à une fréquence qui soit N fois la fréquence de Larmor. Pour résoudre ce problème, la présente invention prévoit un système d'initialisation de la boucle. Selon ce système, l'amplitude du signal de sortie de l'amplitude 31 est détectée par un détecteur d'amplitude 40 tel qu'un détecteur synchrone, détectant cette amplitude pour la fréquence $f_O$ correspondant à la valeur instantanée (divisée par N) de la fréquence de sortie du VCO 36. Quand cette amplitude est inférieure à un minimum prédéterminé, le détecteur d'amplitude 40, agit sur un circuit d'initialisation 41 connecté au circuit de filtrage 34 pour fournir à l'entrée du VCO 36 un signal en forme de rampe de façon à faire varier la fréquence de sortie du VCO sur toute la plage concernée. Quand la fréquence de sortie (divisée par N) de ce VCO 36 passe par la fréquence de résonance de la sonde RMN, un signal est détecté par le détecteur 40 qui inhibe l'action du circuit d'initialisation 41 et la boucle se verrouille automatiquement.

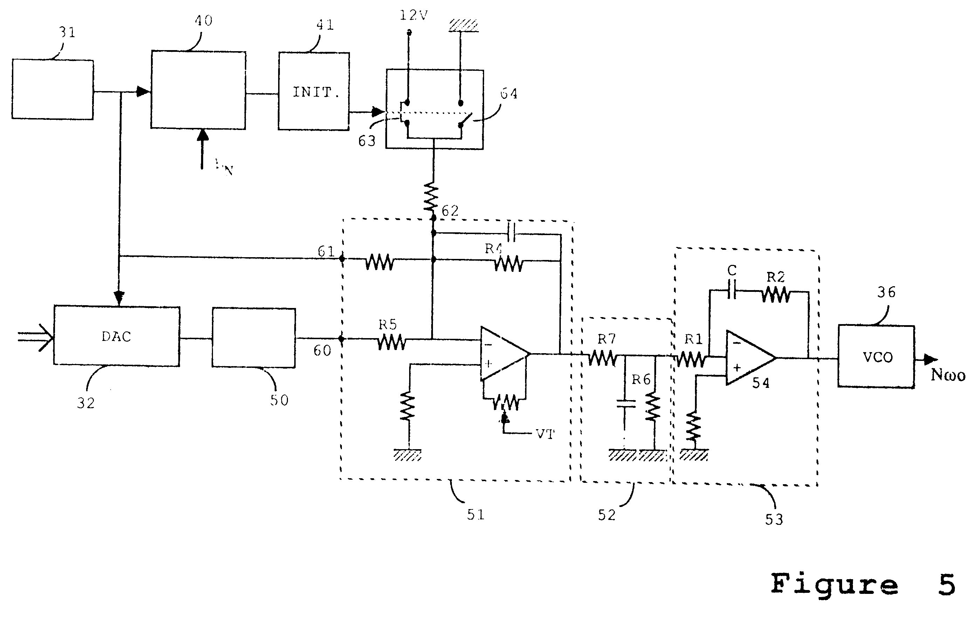

La figure 5 représente plus en détail la partie comprenant le circuit d'initialisation, comprise entre la sortie de l'amplificateur 31 et le VCO 36. On retrouve dans ce schéma le circuit de détection d'amplitude 40, le circuit d'initialisation 41 et le convertisseur numérique/analogique 32. La sortie du convertisseur numérique/analogique 32 est reliée, par l'intermédiaire d'un amplificateur 50, et d'un circuit sommateur 51, à un circuit de filtre passe-bas atténuateur 52. Le circuit 51 et le circuit 52 correspondent au circuit 34 de la figure 4. La sortie du filtre 52 est connectée à un circuit 53 qui assure une fonction d'intégration et d'avance de phase et qui correspond au circuit correcteur 35 de la figure 4. Ce circuit 53 comprend notamment un amplificateur opérationnel 54 qui reçoit le signal à traiter sur son entrée inverseuse par l'intermédiaire d'une résistance R1 et dont la sortie est connectée à cette entrée inverseuse par l'intermédiaire d'un condensateur C en série avec une résistance R2.

Le circuit sommateur 51 reçoit comme première entrée la sortie de l'amplificateur 50 sur une borne 60 ; il reçoit également le signal de référence de sortie de l'amplificateur 31 sur une borne 61 et le signal du circuit d'initialisation sur une borne 62. L'entrée sur la borne 61 est utilisée classiquement pour effectuer la suppression d'une fraction de la tension de référence. Le circuit d'initialisation 41 est connecté à la borne 62 par l'intermédiaire d'un circuit qui peut être schématisé comme comprenant deux interrupteurs 63 et 64. Une fois que la boucle est verrouillée, le commutateur 64 est fermé et le commutateur 63 est ouvert et l'entrée sur la borne 62 n'a aucun effet. Toutefois, dans une phase initiale, quand on veut "accrocher" la boucle, l'interrupteur 64 est ouvert et l'interrupteur 63 est fermé comme cela est représenté sur la figure et un signal à niveau haut est appliqué sur la borne 62. Ce signal, une fois transmis au circuit correcteur 53 qui a une fonction de filtre proportionnel-intégral, applique à l'entrée du VCO une rampe de tension pour rechercher la zone d'accrochage. Quand la fréquence du VCO passe par la valeur $Nf_O$, le détecteur synchrone 40, qui a pour première entrée le signal de sortie de l'amplificateur 31 et pour deuxième entrée le bit de poids fort $b_N$ du compteur 37 qui change d'état à la fréquence $f_O$, et dont la sortie est proportionnelle à l'amplitude du signal de la première entrée, voit sa sortie passer d'une valeur faible bruitée mais constante à une valeur crête importante. Un détecteur à seuil, qui compare cette sortie à un seuil fixe mais ajustable, fait basculer les relais 63 et 64 dès que le niveau du seuil est dépassé. La tension à l'entrée du VCO se bloque et la boucle s'asservit, aucun signal n'étant appliqué sur la borne 62 du circuit sommateur 51.

D'autre part, sur la figure 5, on notera que des paramètres déterminants pour la stabilité de la boucle et pour la détermination de la largeur de bande du filtre suiveur équivalent à cette boucle sont le temps de relaxation T de la sonde RMN, le gain $K_p$ du convertisseur numérique/analogique 32 et de son amplificateur de sortie 50, et le gain $K_v$ du VCO 36 associé à son compteur 37 correspondant à un diviseur par N. Il faut également tenir compte des paramètres de constantes de temps définies par le filtre correcteur, c'est-à-dire essentiellement les constantes $\tau_1$ et $\tau_2$ :

$$\tau_1 = R1C, \text{ et } \tau_2 = R2C,$$

la résistance R2 et le condensateur C étant placés dans la boucle de réaction de l'amplificateur 54 du filtre proportionnel intégral ou filtre actif du second ordre 53 et la résistance R1 étant la résistance d'entrée représentée en figure 5.

Les valeurs de $\tau_1$ et $\tau_2$ sont choisies en fonction des paramètres $K_p$, $K_v$, T, $\omega_n$ et $\xi$, $\omega_n$ et $\xi$ étant deux paramètres bien connus de l'homme de l'art qui fixent respectivement la largeur de bande et le degré de stabilité du système en boucle fermée. Les expressions de $\tau_1$ et $\tau_2$ sont obtenues de la façon qui suit :

- on peut montrer que la fonction de transfert en boucle ouverte du système décrit par la figure 3 dans laquelle le réseau correcteur 23 aurait été débranché, est

$$\Delta\phi/\Delta u \neq K_p K_v[T/(1 + Tp)]$$

où . $\Delta\phi$ est la sortie du comparateur de phase pour une excitation $\Delta u$ (en tension) à l'entrée du VCO dont la variation de fréquence autour de sa valeur nominale est $\Delta f = K_v \Delta u$

. $K_p$ est le gain statique du comparateur de phase 22

. p est l'opérateur de Laplace, bien connu de l'homme de l'art.

- on choisit comme réseau correcteur un réseau bien connu du type proportionnel-intégral car il assure une erreur $\Delta\phi$ nulle en régime permanent, donc une oscillation à la fréquence $f = \omega/2\pi$ selon la formule $\omega = \omega_O + (1/T)tg\phi$ où $\phi$ est un déphasage hors de la boucle à asservissement de phase (amplificateur 31, bobinage 4), et une stabilité non conditionnelle du système en boucle fermée. La formule de ce réseau est

$$(1 + \tau_2 P)/\tau_1 P$$

- on peut montrer que la fonction en boucle fermée T(p) du système s'obtient à partir de la fonction en boucle ouverte totale $\zeta(p)$ ci-dessous

$$\zeta(p) = K_p K_v[T/(1 + Tp)][1 + \tau_2 p)/\tau_1 p]$$
$$T(p) = \zeta(p)/[1 + \zeta(p)]$$
$$= (1 + \tau_2)/[1 + [(\tau_1/TK) + \tau_2]p + (\tau_1/K)p^2]$$

où $K = K_p . K_v$

De façon classique, on définit pour cette fonction de transfert dite du deuxième ordre, les paramètres

. $\omega_n = (K/\tau_1)^{1/2}$ appelé pulsation propre du système est représentatif de la bande de bruit et de la rapidité de réponse du système

. $\xi = (1/2)[1/\omega_n T] + \tau_2 \omega_n]$ appelé coefficient d'amortissement qui est représentatif du degré de stabilité du système.

Pour minimiser le temps de réponse du système, on prend très souvent $\xi \# 0,5$ à 0,707.

On observe que $\omega_n$ ne dépend pas de la sonde RMN ; par contre la stabilité de la boucle dépend du temps de relaxation T de la sonde.

En fonction des paramètres $\omega_n$ et $\zeta$, on peut définir la bande de bruit de la boucle fermée comme la bande d'un filtre rectangulaire équivalent ayant la même variance pour un bruit blanc identique sur les deux filtres et superposé au signal. On montre que cette bande peut s'exprimer mathématiquement en fonction des paramètres $\omega_n$ et qui sont respectivement la pulsation propre et l'amortissement du système en boucle fermée par :

$$N_{BW} = (\omega_n/2)/( \zeta + 1/4\zeta), \text{ en Hz.}$$

A titre d'exemple, et pour illustrer l'originalité de l'invention, en particulier en ce qui concerne le réseau correcteur, on choisit $K_p$, $K_v$, $\tau_1$ pour avoir $\omega_n$ le plus faible possible :

$K_p$ : on peut de façon pratique réaliser un gain de comparateur de phase de 1/80 sans dégrader les performances du déphasage causées par les dérives de décalage de zéro des amplificateurs 50 et 51. Pour cela, on assure un gain du multiplieur, constitué du convertisseur numérique/analogique 32 et de l'amplificateur 50 de 1V/rd. Le gain de l'amplificateur- filtre- sommateur 51 est de $1/8 = R_4/R_5$.

L'atténuateur filtre 52 a un gain statique de $R_5/(R_6 + R_7) = 1/10$ (les résistances R4 et R7 sont indiquées sur la figure 5).

$K_v$ : le VCO 36 est polarisé de façon connue pour avoir un gain de 1600(rd/S)/volt.

$\tau_1 = R_1 C$ : de façon pratique, on peut choisir

R1 = 2M $\Omega$ et C = 10 $\mu$F, car l'amplificateur 53 est choisi pour avoir une impédance d'entrée élevée, et un courant de fuite très faible, comme la capacité C.

On obtient : $\omega_n = [(1600/80)/20]^{1/2} = 1$ rd/s.

Si de façon classique, on désire obtenir un amortissement égal à 0,5, on détermine $\tau_2 = R_2 C$ comme ci-dessous, sachant que T #2 secondes :

$$(1/\omega_n T) + \tau_2 \omega_n = 2 \xi = 1$$

soit

$$\tau_2 = 1 - (1/T) = 1/2$$

d'où

$$R_2 = 1/(2 \cdot 10^{-5}) = 50 \text{ k}\Omega$$

On observe ainsi la dépendance du choix de $R_2$ par rapport au temps de relaxation pour obtenir l'amortissement désiré.

Selon un autre aspect de la présente invention, et en revenant sur la figure 4, on notera que l'on a choisi comme VCO de la boucle de phase un ensemble correspondant au VCO 36, fournissant une fréquence N fois plus élevée que la fréquence à détecter, suivi d'un compteur et d'une mémoire de fonction sinusoïdale 38. Ce choix est notamment dicté par le fait que le signal de sortie de la boucle doit être réinjecté sur la sonde RMN. Il est particulièrement important que ce signal à la fréquence f soit exempt d'harmoniques pour éviter que cette sonde oscille sur l'une de ses fréquences propres. En effet, dans de nombreuses réalisations, la sonde présente une fréquence propre à quelques kHz, par exemple 14 kHz, qui, si elle était excitée, rendrait impossible la détection de la fréquence recherchée située entre 1000 et 3000 Hz. Le fait d'utiliser successivement une mémoire à 256 positions 42 pour définir une fonction sinusoïdale échantillonnée suivie d'une bascule tampon 43 et d'un convertisseur numérique/analogique 44 permet de fournir à la sonde un signal exempt d'harmoniques dans la bande 0-30 kHz ce qui ne serait pas le cas si on utilisait directement la sortie d'un VCO réglé sur la fréquence voulue qui est un signal rarement parfaitement sinusoïdal et qui devrait lui-même être refiltré par un filtre suiveur à commutation de capacités de type connu avant d'être injecté à la sonde à RMN, puis mis sous forme "carrée" pour attaquer le multiplieur du comparateur de phase. C'est aussi un avantage au niveau du comparateur de phase 32 que l'entrée de la boucle soit aussi sinusoïdale que possible pour améliorer la qualité de la comparaison de phase fournie par le convertisseur numérique/analogique 32. Pour satisfaire aux relations de phase souhaitées, la mémoire 38 contient la fonction $\cos(2\pi i/N)$ et la mémoire 42, la fonction $\sin(2\pi i/N)/$

Bien entendu, la présente invention est susceptible de nombreuses variantes quant à la réalisation de chacun des blocs de circuit et même, dans certains cas, de leur agencement relatif, comme cela apparaîtra à l'homme de l'art.

Par exemple, comme circuit d'initialisation, on pourrait adopter une structure autre que celle à détecteur synchrone décrite ci-dessus. On pourrait utiliser pour réaliser transitoirement la fonction de détection d'amplitude la sortie du convertisseur analogique/numérique après un filtrage équivalent à 34 puisqu'il s'agit là d'un multiplieur quasi-sinusoïdal. Cette sortie amplifiée et filtrée sera comparée à un seuil choisi en fonction du niveau moyen du bruit. Tant qu'elle est inférieure au seuil, le VCO 36 fournit une fréquence continuement variable. Dès qu'elle atteint le seuil, c'est-à-dire que la sortie du VCO est proche de la fréquence de Larmor, la boucle se verrouille.

## Revendications

1. Magnétomètre oscillateur à résonance nucléaire dont la fréquence d'oscillation est proportionnelle à l'intensité du champ magnétique ambiant, utilisé en vue de la mesure dudit champ magnétique, et comprenant une sonde magnétométrique (30) à résonance magnétique pour détecter, en réponse à un signal d'excitation basse fréquence, un signal à la fréquence de ladite résonance magnétique et des moyens (31, 33, 40, 41) pour engendrer, en réponse au signal détecté, ledit signal d'excitation basse fréquence, caractérisé par le fait que lesdits moyens de génération comprennent une boucle (33) d' asservissement de la phase dudit signal d'excitation basse fréquence sur la phase dudit signal détecté, et des moyens d'initialisation (40,41) pour que ledit signal d'excitation basse fréquence balaye une plage de fréquences lorsque ladite boucle (33) n'est pas accrochée.

2. Magnétomètre oscillateur à résonance nucléaire selon la revendication 1, caractérisé par le fait que lesdits moyens de génération délivrent ledit signal d'excitation basse fréquence sous forme numérique, et que ladite boucle (33) utilise, comme comparateur de phase, un premier convertisseur numérique/analogique (32) dont l'entrée numérique reçoit ledit signal d'excitation basse fréquence sous forme numérique et dont l'entrée de polarisation reçoit ledit signal détecté par ladite sonde (30).

3. Magnétomètre oscillateur à résonance nucléaire selon la revendication 2, caractérisé par le fait que lesdits moyens de génération comprennent :
   - un oscillateur (36) à fréquence commandée par la tension de sortie du comparateur de phase et fournissant un signal en créneaux, de fréquence égale à N fois la fréquence dudit signal d'excitation basse fréquence, N étant un entier positif,
   - un compteur (37) de capacité N recevant la sortie dudit oscillateur (36) à fréquence commandée et délivrant donc en sortie un signal numérique dont la valeur varie de 1 à N de façon cyclique, et,
   - une première mémoire (38), adressée par ledit compteur (37), contenant des valeurs d'une fonction sinusoïdale de $2\pi i/N$, dont la sortie est ledit signal d'excitation basse fréquence sous forme numérique.

4. Magnétomètre oscillateur à résonance nucléaire selon la revendication 3, caractérisé par le fait que N est compris entre 32 et 4096 ($2^5$ et $2^{12}$).

5. Magnétomètre oscillateur à résonance nucléaire selon la revendication 3, caractérisé par le fait que ledit signal d'excitation basse fréquence appliqué à ladite sonde (30) est obtenu à partir d'une deuxième mémoire (42) contenant des valeurs d'une fonction sinusoïdale de $2\pi i/N$, décalée de 90° par rapport à celle de ladite première mémoire (38), adressée par ledit compteur (37) modulo N, et dont la sortie est transmise à ladite sonde (30) par l'intermédiaire d'un deuxième convertisseur numérique/analogique (44).

## Patentansprüche

1. Kernresonanz-Magnetometeroszillator, dessen Oszillationsfrequenz proportional zur Stärke des Magnetfeldes in seiner Umgebung ist und der hinsichtlich der Messung dieses Magnetfeldes verwendet wird, umfassend eine magnetometrische Sonde (30) für Magnetresonanz, um in Abhängigkeit von einem niederfrequenten Erregersignal ein Signal mit der Frequenz dieser Magnetresonanz zu detektieren, und Mittel (31, 33, 40, 41), um in Abhängigkeit vom detektierten Signal das genannte niederfrequente Erregungssignal zu erzeugen, dadurch gekennzeichnet, daß die Mittel zur Erzeugung einen Kreis(33) zur Regelung der Phase des niederfrequenten Erregersignals mittels der Phase des detektierten Signals umfassen, sowie Mittel zur Initialisierung (40, 41), so daß das niederfrequente Erregersignal einen Frequenzbereich überstreicht, solange der Kreis (33) nicht verriegelt ist.

2. Kernresonanz-Magnetometeroszillator nach Anspruch 1, dadurch gekennzeichnet, daß die Mittel zur Erzeugung das niederfrequente Erregersignal in digitaler Form liefern und daß der Kreis (33) als Phasenkomparator einen ersten Digital-Analog-Wandler (32) verwendet, dessen Digitaleingang das niederfrequente Erregersignal in digitaler Form empfängt und dessen Polarisationseingang das von der Sonde (30) ermittelte Signal empfängt.

3. Kernresonanz-Magnetometeroszillator nach Anspruch 2, dadurch gekennzeichnet, daß die Mittel zur Erzeugung umfassen:
   - einen Oszillator (36) mit einer von der Ausgangsspannung des Phasenkomparators gesteuerten Frequenz, welcher Oszillator ein Rechtecksignal mit einer Frequenz, die dem N-fachen der Frequenz des niederfrequenten Erregersignals entspricht, liefert, wobei N eine positive ganze Zahl ist,
   - einen Zähler (37) der Kapazität N, der das Ausgangssignal des Oszillators (36) mit gesteuerter Frequenz empfängt und somit am Ausgang ein digitales Signal liefert, dessen Wert zyklisch von 1 bis N variiert, und
   - einen ersten Speicher (38)), den von dem Zähler (37) adressiert wird und Werte einer sinusförmigen Funktion von 2 $\pi i/N$ enthält und dessen Ausgangsgröße das niederfrequente Erregersignal in digitaler Form ist.

4. Kernresonanz-Magnetometeroszillator nach Anspruch 3, dadurch gekennzeichnet, daß N zwischen 32 und 4096 ($2^5$ und $2^{12}$) beträgt.

5. Kernresonanz-Magnetometeroszillator nach Anspruch 3, dadurch gekennzeichnet, daß das an die Sonde (30) angelegte niederfrequente Erregersignal mittels eines zweiten Speichers (42) erhalten wird, der Werte einer sinusförmigen Funktion von 2 $\pi i/N$ enthält, die in bezug auf die Funktion des ersten Speichers (38) um 90° verschoben ist, welcher Speicher von dem modulo N-Zähler (37) adressiert wird und dessen Ausgangssignal über einen zweiten Digital-Analog-Wandler (44) zur Sonde (30) übertragen wird.

## Claims

1. Magnetic resonance oscillator magnetometer whose oscillation frequency is proportional to the intensity of the ambient magnetic field, used for measuring said magnetic field, and comprising a magnetic resonance magnetometric probe (30) for detecting a signal at the frequency of said magnetic resonance in response to a low frequency excitation signal, and means (31,33,40,41) for generating said low frequency excitation signal in response to the detected signal, characterized by the fact that said generation means comprise a loop (33) for locking the phase of said low frequency excitation signal to the phase of said detected signal, and initialization means (40,41) so that said low frequency excitation signal sweeps a range of frequencies when said loop (33) is not locked.

2. Magnetic resonance oscillator magnetometer according to claim 1, characterized by the fact that said generation means delivers said low frequency excitation signal in digital form and said loop (33) uses, as phase comparator, a first D-A converter (32) whose digital input receives said low frequency excitation signal in digital form and whose bias input receives said signal detected by said probe (30).

3. Magnetic resonance oscillator magnetometer according to claim 2, characterized by the fact that said generation means comprise :
   - an oscillator (36) whose frequency is controlled by the output voltage of the phase comparator and which delivers a square wave signal, of a frequency equal to N times the frequency of said low frequency excitation signal, N being a positive integer,
   - a counter (37) of capacity N receiving the output of said controlled frequency oscillator (36) and thus outputting a digital signal whose value varies from 1 to N cyclically, and
   - a first memory (38), addressed by said counter (37), containing values of a sinusoidal function of 2 $\pi i/N$, whose output is said low frequency excitation signal in digital form.

4. Magnetic resonance oscillator magnetometer according to claim 3, characterized by the fact that N is be-tween 32 and 4096 ($2^5$ and $2^{12}$).

5. Magnetic resonance oscillator magnetometer according to claim 3, characterized by the fact that said low frequency excitation signal applied to said probe (30) is obtained from a second memory (42) containing values of a sinusoidal function of $2\pi i/N$, shifted by 90° with respect to that of said first memory (38), addressed by said counter (37) of capacity N and whose output is fed to said probe (30) through a second D-A converter (44).

ART ANTERIEUR

Figure 1

Figure 2A

Figure 2B

Figure 3

Figure 4

Figure 5

EP 0 326 474 B1